Europäisches Patentamt

European Patent Office

Office européen des brevets

(19)

(11) Publication number: **0 187 237 B1**

(12) **EUROPEAN PATENT SPECIFICATION**

(45) Date of publication of patent specification: **25.03.92**  (51) Int. Cl.5: **H01L 27/10**, H01L 21/82

(21) Application number: **85114821.3**

(22) Date of filing: **22.11.85**

(54) dRAM cell and method.

(30) Priority: **07.12.84 US 679663**

(43) Date of publication of application:
**16.07.86 Bulletin 86/29**

(45) Publication of the grant of the patent:
**25.03.92 Bulletin 92/13**

(84) Designated Contracting States:
**DE FR GB**

(56) References cited:
**EP-A- 0 108 390**

**PATENTS ABSTRACTS OF JAPAN, vol. 8, no. 63 (E-233)[1500], 24th March 1984; & JP-A-58 213 464**

**PATENTS ABSTRACTS OF JAPAN, vol. 8, no. 103 (E-244)[1540], 15th May 1984; & JP-A-59 19 366**

**PATENTS ABSTRACTS OF JAPAN, vol. 4, no. 48 (E-6)[530], 12th April 1980; & JP-A-55 19 820**

(73) Proprietor: **TEXAS INSTRUMENTS INCORPORATED**
**13500 North Central Expressway**
**Dallas Texas 75265(US)**

(72) Inventor: **Chatterjee, Pallab K.**
**1107 Haynes Drive**
**Richardson, TX 75281(US)**
Inventor: **Richardson, William F.**
**1109 Princeton**
**Richardson, TX 75081(US)**
Inventor: **Malhi, Satwinder**
**2626 Meadowridge Drive**
**Garland, TX 75042(US)**

(74) Representative: **Leiser, Gottfried, Dipl.-Ing. et al**
**Patentanwälte Prinz, Leiser, Bunke & Partner**
**Manzingerweg 7**
**W-8000 München 60(DE)**

EP 0 187 237 B1

## Description

## BACKGROUND

The present invention relates to a dynamic semiconductor memory cell as defined in the precharacterizing part of claim 1.

The development of large monolithic dynamic random access memories (dRAMs) has run into many problems, and one of the most important of these problems is that of shrinking the dRAM cell size without increasing the soft-error rate in order to pack more cells on a chip. Large dRAMs are silicon based and each cell typically includes a single MOS field effect transistor with its source connected to a storage capacitor, its drain connected to a bit line, and its gate connected to a word line; the cell operates by storing a charge on the capacitor for a logic 1 and not storing any charge for a logic 0. Traditionally the cell capacitor has been formed by an inversion layer separated from an overlying electrode by a thin oxide layer and from the substrate by a depletion layer. However, to maintain stable circuit operation the capacitance must be large enough to yield a sufficient signal to noise ratio, and this leads to large substrate area devoted to the capacitor. Further, such a MOS capacitor is vulnerable to charges generated in the substrate by alpha particles (a 5 MeV alpha particle can produce more than 200 femtocoulombs of hazardous electrons), noise injected from the substrate, pn junction leakage over the entire area of the capacitor, and subthreshold leakage of the cell transistor. A typical stored charge in a dRAM cell is 250 fC. For a five volt power supply this requires a storage capacitor of 50 fF; and with a storage oxide thickness of 150 A, a capacitor area of about 20 square microns (1 square micron = $1\mu m^2$) is needed. This imposes a lower limit on the cell size if conventional two dimensional technology is used.

One approach to solve these problems appears in Jolly et al, A Dynamic RAM Cell in Recrystallized Polysilicon, 4 IEEE Elec. Dev.Lett. 8 (1983) and forms all basic elements of the cell, including both the access transistor and the charge storage capacitor, in a layer of beam recrystallized polysilicon deposited on an oxide layer on a silicon substrate The bit line is contained in the recrystallized polysilicon layer, and turning on the transistor causes charge to flow into the storage region, which is composed of heavily doped, recrystallized polysilicon surrounded on the top, bottom, and three sides by thermally grown oxide. The storage capability is about twice that of a conventional capacitor of the same storage area since ground electrodes both above and below are separated from the storage region in the recrystallized polysilicon by capacitor insulator oxides. In addition, the lower oxide isolates the storage region from any charge injected into the substrate either from surrounding circuitry or by alpha particles or other radiation generating soft errors. Further, thick oxide under the bit line and complete sidewall oxide isolation reduce the bit-line capacitance. However, even doubling the capacitance over the traditional design fails to sufficiently shrink the area occupied by the cell capacitor. Further, beam recrystallization disturbs underlying structures and is not a simple, established process.

A second approach to shrinking dRAM cell size relies on a capacitor with plates extending into the substrate. This capacitor, called a corrugated capacitor, is described in H.Sunami et al, A Corrugated Capacitor Cell (CCC) for Megabit Dynamic MOS Memories, IEEE IEDM Tech Digest 806 (1982); H.Sunami et al, A Corrugated Capacitor Cell (CCC) for Megabit Dynamic MOS Memories, 4 IEEE Elec.Dev.Lett. 90 (1983); and K.Itoh et al, An Experimental 1Mb DRAM with On-Chip Voltage Limiter, 1984 IEEE ISSCC Digest of Tech Papers 282. The corrugated capacitor extends about 2.5 microns into the silicon substrate. Fabrication proceeds as follows: Trenches are formed by ordinary reactive sputter etching with $CCl_4$ gas using a CVD silicon dioxide film mask; a wet etch cleans up any dry etching damage and contaminations. After trench formation, a triple storage layer of silicon dioxide/silicon nitride/silicon dioxide is formed on the trench walls. Lastly, the trench is filled with LPCVD polysilicon. Use of the corrugated capacitor assertedly yields more than seven times the capacitance of the conventional cell, with a three micron by seven micron cell having a 60 fF storage capacitance.

A third approach to shrink the area occupied by the cell capacitor is similar to the approach described in the preceding paragraph and forms the capacitor in a trench. For example, E.Arai, Submicron MOS VLSI Process Technologies, IEEE IEDM Tech Digest 19 (1983); K.Minegishi et al, A Submicron CMOS Megabit Dynamic RAM Technology Using Doped Face Trench Capacitor Cell, IEEE IEDM Tech Digest 319 (1983); and T.Morie et al, Depletion Trench Capacitor Technology for Megabit Level MOS dRAM, 4 IEEE Elec.Dev.Lett. 411 (1983) all describe a cell with a traditional design except for the capacitor which has been changed from plates parallel to the substrate to plates on the walls of a trench in the substrate. Such a trench capacitor permits large capacitance per unit area of substrate by simply using a deep trench. The capacitors described in these articles were fabricated as follows: Starting with (100) oriented, p-type, 4-5 ohm-cm resistivity silicon substrates, trench patterns with 0.4-1.0 micron (1 mi-

cron = 1μm) width were formed by electron-beam direct writing. Trenches of 1-3 micron depth were then excavated by reactive ion etching with $CBrF_3$ at a pressure of about 14 mTorr; the trench surfaces were cleared of RIE damage by an etch in a mixture of nitric, acetic, and hydrofluoric acids. PSG was then deposited by CVD using a $PH_3/SiH_4/O_2$ gas system, the phosphorus diffused into the trench surface layers, and the PSG etched away by hydofluoric acid. $SiO_2$ of 150-500 A (10A = 1μm) was grown in dry $O_2$ or CVO $Si_3N_4$ was deposited 500 A thick on the trench walls. Lastly, the trenches were filled with LPCVD polysilicon. The capacitance per unit area of trench sidewall was comparable to the capacitance per unit area of a traditional capacitor; consequently, deep trench capacitors can shrink cell substrate area by enhancing the storage capacitor area per unit substrate area. However, the cell transistor in these trench capacitor cells is formed in the bulk substrate adjacent to the capacitor and is not isolated as in the first approach.

For further example, EP-A-0 108 390 shows in Figure 15 thereof a memory cell comprising a field effect transistor formed in semiconductor material and an insulated storage node formed in a trench in said material. A yet further example of a storage capacitor formed in a trench is shown in the Figure associated with No. 63 (E-233) (1500) of vol. 8 of Patent Abstracts of Japan, 24/3/85.

The use of trenches for isolation is also well known and has been extensively studied; for example, R.Rung et al, Deep Trench Isolated CMOS Devices, IEEE IEDM Tech Digest 237 (1982); K.Cham et al, A Study of the Trench Inversion Problem in the Trench CMOS Technology, 4 IEEE Elec.Dev.Lett. 303 (1983); A.Hayasaka et al, U-Groove Isolation Technique for High Speed Bipolar VLSI's, IEEE IEDM Tech Digest 62 (1982); H.Goto et al, An Isolation Technology for High Performance Bipolar Memories --IOP-II, IEEE IEDM Tech Digest 58 (1982); T.Yamaguchi et al, High-Speed Latchup-Free 0.5-um-Channel CMOS Using Self-Aligned $TiSi_2$ and Deep-Trench Isolation Technologies, IEEE IEDM Tech Digest 522 (1983); S.Kohyama et al, Directions in CMOS Technology, IEEE IEDM Tech Digest 151 (1983): and K.Cham et al, Characterization and Modeling of the Trench Surface Inversion Problem for the Trench Isolated CMOS Technology, IEEE IEDM Tech Digest 23 (1983). These isolation trenches are formed in a manner similar to that described for the trench and corrugated capacitors; namely, patterning (typically with oxide mask), RIE with $CBrF_3$, $CCl_4$, $Cl_2$-$H_2$, $CCl_4$-$O_2$, etc. excavation, thermal oxidation (plus LPCVD nitride) of the sidewalls, and filling with polysilicon.

However, the beam recrystallized cell occupies too much substrate area and the trench capacitor cells fail to isolate the transistor and capacitor storage plate from the substrate. And all of these cells do not minimize the substrate area occupied.

## SUMMARY OF THE INVENTION

The present invention provides a dynamic semiconductor memory cell formed in a semiconductor material and comprising a capacitor with first and second capacitor electrodes formed in a trench in said substrate and a field effect transistor connected to said capacitor, characterized in that said first capacitor plate includes a portion of the sidewalls of said trench and said second capacitor plate includes material inserted into said trench and in that the channel of the field effect transistor is formed in semiconductor material inserted into said trench and is adjacent to the trench sidewalls and conductively connected to said second capacitor plate the gate of the field effect transistor being formed adjacent to and outside of the trench.

## BRIEF DESCRIPTION OF THE DRAWINGS

Figs. 1A-B are the schematic equivalent circuit and local memory array geometry for the preferred embodiment dRAM cells and array;

Fig. 2 is a schematic cross sectional elevation of a first preferred embodiment dRAM cell taken along line 2-2 of Fig. 1B;

Figs. 3A-C illustrate a sequence of process steps of a first preferred embodiment method of fabrication of the first preferred embodiment dRAM cell;

Fig. 4 illustrates a second preferred embodiment dRAM cell;

Figs. 5A-B are schematic cross sectional and plan views of a third preferred embodiment dRAM cell;

Figs. 6A-G illustrate a sequence of process steps of a third preferred embodiment method of fabrication of the third preferred embodiment dRAM cell;

Fig. 7 is a schematic cross sectional view of a fourth preferred embodiment dRAM cell;

Fig. 8 is a schematic cross sectional elevation of a fifth preferred embodiment dRAM cell taken along line 8-8 of Fig. 1B;

Figs. 9A-G illustrate a sequence of process steps of a fifth preferred embodiment method of fabrication of the fifth preferred embodiment dRAM cell;

Fig. 10 is a schematic cross sectional elevation of a sixth preferred embodiment dRAM cell;

Figs. 11A-G illustrate a sequence of process steps of a sixth preferred embodiment method of fabrication of the sixth preferred embodiment dRAM cell;

Figs. 12A-E are schematic cross sectional elevations of seventh and eighth preferred embodiment dRAM cells and illustrative process steps of preferred embodiment methods of fabrication.

## DESCRIPTION OF THE PREFERRED EMBODIMENTS

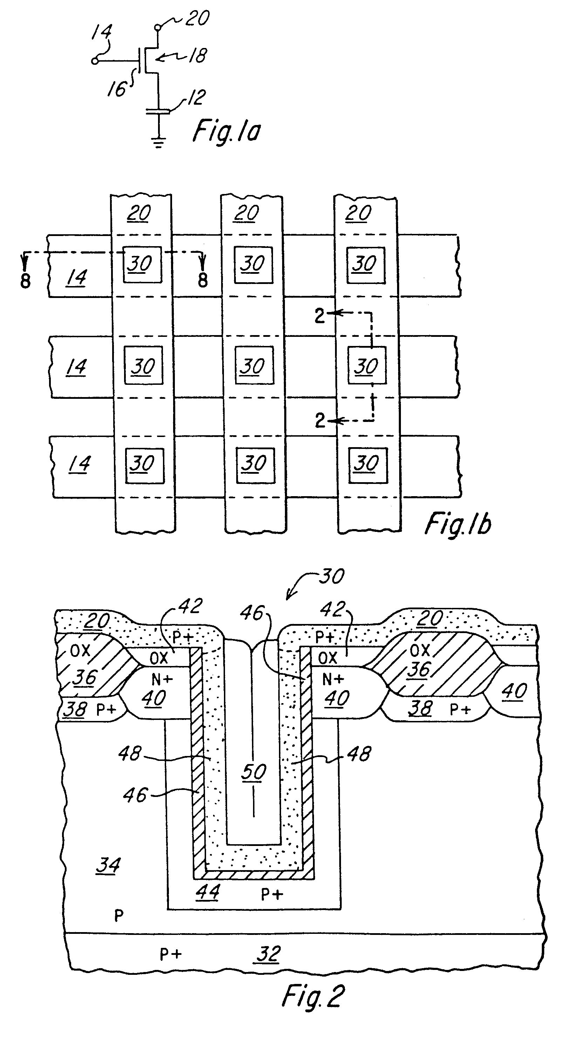

The preferred embodiment dRAM cells are one transistor/one capacitor cells connected to bit line 20 and word line 14 as shown in schematic Fig. 1A and operate as follows. Capacitor 12 stores charge to represent a bit of information (for example, no stored charge could represent a logic 0 and the stored charge corresponding to a potential of 5 volts across the capacitor plates could represent a logic 1). The bit of information is accessed (to read or to write a new bit) by applying a voltage on word line 14 connected to gate 16 to turn ON transistor 18; a turned ON transistor 18 connects capacitor 12 to bit line 20 for the read or write operations. Leakage currents and other sources of decay of the charge on capacitor 12 necessitate periodic refreshing of the charge, and thus the name dynamic RAM (dRAM).

Fig. 1B is a plan view showing a portion of a dRAM array of bit lines 20 and word lines 14 with preferred embodiment cells 30 at the intersections of the lines; note that bit lines 20 pass under word lines 14 in Fig. 1B, although the reverse is also used. The cells extend down into the substrate below the lines and provide a maximal density memory. If the minimum feature size is denoted by f and the minimum registration is denoted by R, then the cell area is $[2(f+R)]^2$. For example, with a minimum feature size of 1.0 micron and a minimum registration tolerance of 0.25 micron, the cell area is about 6.25 square microns.

FIG.2 is a cross sectional view of first preferred embodiment dRAM cell, generally denoted 30. Cell 30 is formed in p+ silicon substrate 32 with p epilayer 34 and includes field oxide 36, p+ channel stops 38, buried n+ gate region 40, word line oxide 42, p+ capacitor plate region 44, capacitor insulator/gate oxide 46, p polysilicon capacitor plate/channel region 48, p+ or silicided polysilicon bit line 20, and oxide 50. The view in FIG.2 corresponds to a cross section along vertical line 2-2 in FIG.1B: region 40 extends in a direction perpendicular to the paper in FIG.2 to form word line 14; and the square cross section of the trench in substrate 32/epilayer 34/buried region 40 containing capacitor 12 and transistor 18 is apparent in FIG.1B.

In cell 30 capacitor 12 is formed with the plates being region 44 and that portion of region 48 opposite region 44; the insulator is that portion of layer 46 between the two plates. Note that the charge is stored on region 48 and thus is isolated from the substrate by the oxide layer 46. For a trench with a 1 micron by 1 micron cross section and 6 microns deep, the capacitor plate area would be about 21 square microns if gate region 40 takes up about 1 micron of the depth.

In cell 30 transistor 18 is a p-channel depletion mode field effect transistor with its source in the capacitor plate portion of layer 48, its channel the cylindrical (with square cross section) remainder of layer 48, its drain the portion of bit line 20 adjacent the channel, and its gate in region 40 which is integral with word line 14. Because the transistor operates in the depletion mode, the gate voltage is normally high, and this reverse biases the junction between gate region 40 and capacitor plate region 44.

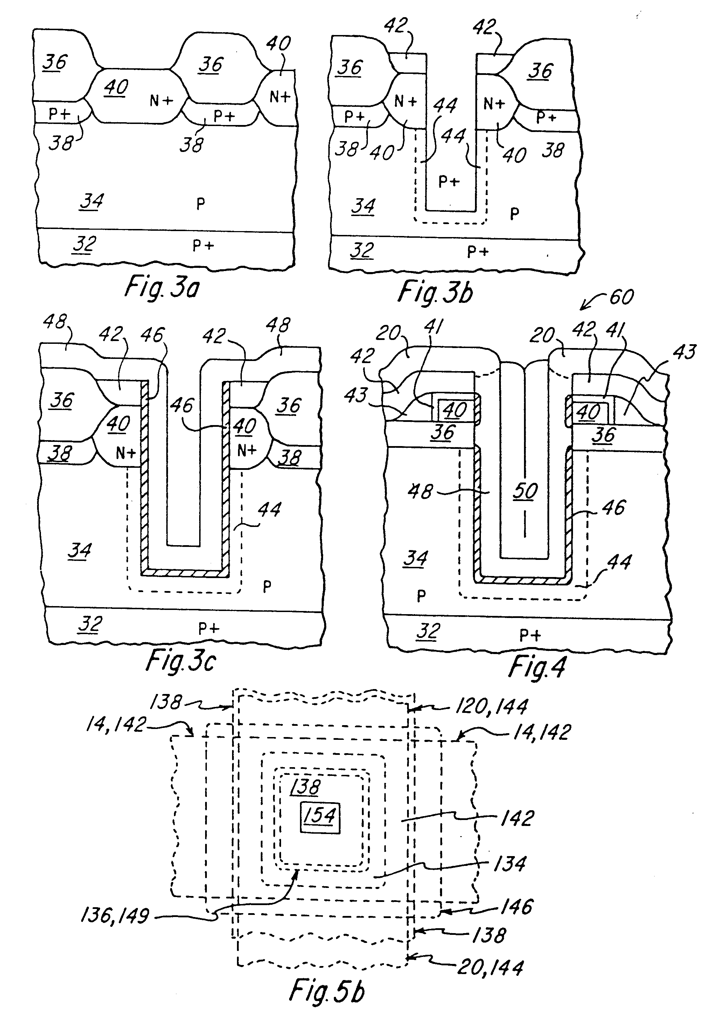

The dimensions and material characteristics of cell 30 are best understood in connection with the following description of a first preferred embodiment fabrication process which is illustrated in sequential cross sectional views in FIGS.3A-D.

1. (100) oriented p+ silicon substrate 32 with p epilayer 34 of resistivity 5-10 ohm-cm has field oxide 36 with channel stops 38 formed in the usual manner: a stress relief oxide layer is grown on epilayer 34 and LPCVD nitride is deposited on the oxide; the active area is patterned and plasma etching removes the nitride and oxide outside the active area; a boron implant using the nitride as a mask creates channel stops 38; and field oxide 36 is grown to a thickness of 1.0 micron. The nitride is patterned for word lines 14/region 40, the stress relief oxide etched, and arsenic implanted to form word lines 14 and regions 40 to be n+ with a carrier density of 1E18 per cubic centimeter. Region 40 is about 2.0 microns wide and 0.7 microns thick; regions 40 are on a 2.5 micron pitch; see FIG.3A.

2. 2,000 A of oxide are grown on region 40; this oxide is patterned for 1.0 micron square trenches and plasma etched. The trenches are then excavated by reactive ion etching (RIE) with $HCl_4$ to a total depth of 3.5 microns using the oxide as a mask. After the trenches have been excavated, they are cleaned of RIE damage and contamination by a wet acid etch. Next, p+ layer 44 is formed by vapor phase diffusion of boron to a depth of about 1,000 A and with a carrier density of 1E17 ($E17 = 1.10^{17}$) per $cm^3$. See FIG.3B.

3. 150 A of oxide 46 is thermally grown on the sidewalls of the trenches, regions 40 and 44, and forms the gate oxide for transistor 18 and the insulator for capacitor 12. 1,000 A of polysilicon 48 doped p to a carrier density of 1E16

per cm$^3$ is deposited by LPCVD and patterned to define bit lines 20. See FIG.3C. That portion of polysilicon 48 opposite region 40 forms the channel of transistor 18, and that portion of polysilicon opposite region 44 forms a plate of capacitor 12.

4. The trench is filled with oxide 50, such as by a side wall process, and the horizontal portion of polysilicon 48 is silicided or doped p + to form bit lines 20; completed cell 30 is shown in FIG.2.

Cell 30 has the following characteristics: transistor 18 is a polysilicon transistor with channel width 4.0 microns, length 0.7 micron and thickness 1,000 A, which typically yields a leakage current of 0.5 pA. Capacitor 12 has a plate area of about 12 square microns and an oxide insulator thickness of 150 A which yields a capacitance of about 22 fF. If cell 30 were to be refreshed when the stored voltage deteriorates 2 volts, then the 22 fF and 0.5 pA indicates a maximum refresh interval of 90 msec. Cell 30 occupies about 6.25 square microns of substrate area, so a 100,000 square mils substrate could probably contain a 4 megabit memory using such cells.

Second preferred embodiment cell 60 is shown in cross sectional elevation in FIG.4 and differs from cell 30 by isolating transistor 18 from capacitor 12 with the oxide layer 36; note that analogous features in cells 30 and 60 are given the same reference numbers. In cell 60, word line 14/gate region 40 is formed by patterning a doped polysilicon layer which has been deposited on oxide layer 36; and after patterning, word line 14/gate region 40 is silicided, forming layer 41 of silicide and thereby lowering the resistance of the word lines. As with cell 30, an insulating oxide 42 is deposited over the word lines and patterned to form the mask for excavation of the trenches; however, for cell 60 the step created by region 40 must be covered by a sloped oxide 43 to avoid formation of spurious devices on the edge of the word lines away from the trenches. The oxides 42 and 43 may be deposited together using plasma enhanced CVD with planarizing sputtering. Otherwise, the fabrication of cell 60 parallels that of cell 30 as the does the performance; note that the channel length of transistor 18 is more easily controlled in cell 30 than in cell 60 because it is determined by the thickness of a diffused layer rather than that of a polysilicon layer.

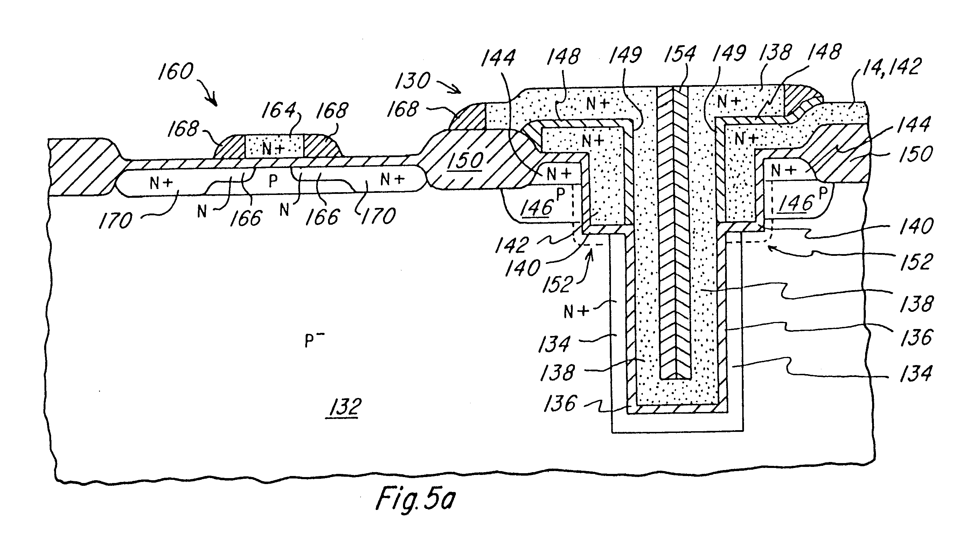

FIG.5A-B are cross sectional and plan views of a third preferred embodiment dRAM cell, generally denoted 130. Cell 130 is formed in p-silicon substrate 132 and includes n + doped plate region 134, capacitor dielectric oxide layer 136, n + polysilicon plate layer 138, gate oxide layer 140, n + polysilicon gate layer 142, n + doped drain region 144, p region 146, insulating oxide layer 148, and field oxide 150. The capacitor of cell 130 is formed with the ground plate being layer 138, the dielectric is oxide layer 136, and the other plate is n + region 134. Thus the capacitor plates and separating dielectric are the bottom and lower sidewall portions of a trench formed in substrate 132; note that with a positive voltage applied to the capacitor plate region 134, the junction between region 134 and substrate 132 is reversed biased. The transistor of cell 130 is formed with region 134 as the source, region 144 as the drain, polysilicon layer 142 as the gate, oxide layer 140 as the gate oxide, and region 152 (shown as dotted lines in FIG.5A) of substrate 132 and region 146 as the channel. Thus, the transistor roughly has the shape of a cylinder with a bottom flange and oriented perpendicular to the plane of substrate 132; see FIG.5B where the top view of gate oxide layer 140 illustrates the approximately square cross section of this cylinder. As shown in FIG.5B word line 14 is formed in layer 142 and is perpendicular to bit line 20 formed in layer 144; a ground line is formed in layer 138 and parallels bit line 20.

The effective length of channel 152 is the thickness of p region 146 because the portion of channel 152 in substrate 132 is much more lightly doped than p region 146 and only acts as a drift region as in double diffused MOS; also, the doping density of region 46 may be adjusted in order to adjust the threshold voltage of the transistor. Note that polysilicon layer 138 may not completely fill the trench (depending on the thickness of layer 138 and the width of the trench) and the gap is filled with oxide 154. FIG.5B also shows a field effect transistor 160 which can be fabricated simultaneously with cell 130 and may be used for the peripheral circuitry of a dRAM.

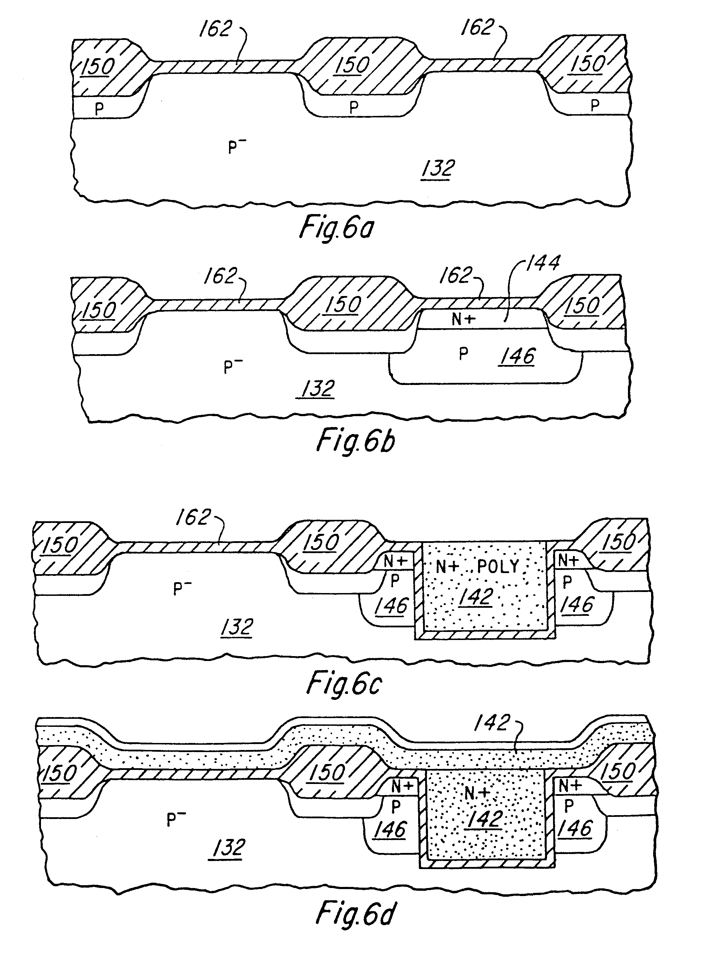

The dimensions and material characteristics of cell 130 are best understood in connection with the following description of a possible fabrication method which is illustrated by cross sectional views in FIGS.6A-G.

1. (100) oriented p- silicon substrate 132 with resistivity 5-10 ohm-cm has field oxide 150 with channel stops 156 formed in the usual manner: substrate 132 is covered with oxide, nitride, and oxide layers; the top oxide layer is patterned and a high energy boron implant through the exposed nitride and bottom layers creates channel stops 156; the patterned oxide is used as a mask to etch the nitride; the patterned oxide is stripped and the patterned nitride used as a mask for growing field oxide 150 to a thickness of about 5,000 A; and the nitride is stripped and protective oxide layer 162 grown; see FIG.6A.

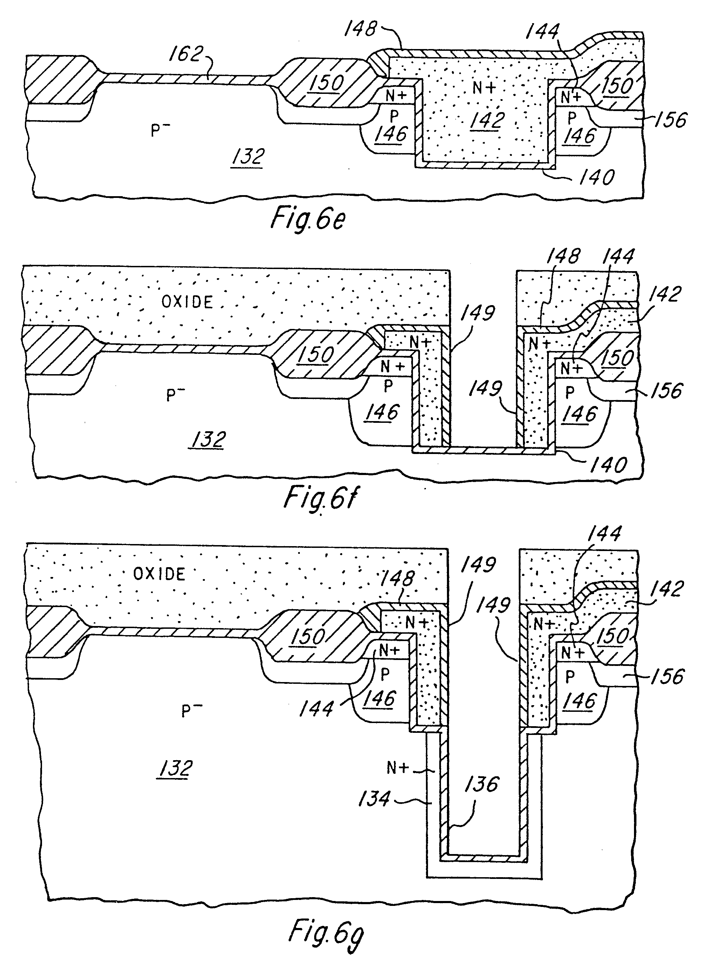

2. The peripheral regions (lefthand portion of F1G.6) are masked, and boron and arsenic implants create regions 144 and 146, respectively.

Region 146 is doped to about 1E17 carriers per cubic centimeter and is one micron thick; region 144 is doped to about 1E19 carriers per cubic centimeter and is about 2,000 A thick. Note that bit line 20 is formed in layer 144; see FIG.6B.

3. A layer of CVD nitride is applied and is patterned to define transistor trenches, and the trenches are excavated by RIE using CCl$_4$ to a depth of about 1.2 microns which is about the bottom of region 146. The trenches are about 2.5 microns square, and after excavation, the trench is cleaned of RIE damage and contamination by a wet acid etch, and a thermal oxide layer grown to form gate oxide foyer 140. The RIE nitride mask is stripped. The transistor trench is then filled by a deposition of LPCVD polysilicon 142 doped n + to 1E19 which is planarized in the usual manner of spinning on material such as PMMA and plasma etching the polysilicon-PMMA combination down to the oxides 150 and 162 see FIG.6C.

4. A 2,000 A layer of additional doped polysilicon 142 is deposited by LPCVD and a layer of oxide grown on it; see FIG.6D.

5. The polysilicon layer deposited in step 4 is patterned and etched to form word lines 14, and an insulating layer of oxide 148 grown; see FIG.6E.

6. A 1.0 micron layer of CVD oxide is deposited and patterned to define the storage trenches about 1.5 microns square which are then excavated by RIE with CCl$_4$ in two stages. First the storage trench is excavated down to oxide layer 140 at the bottom of the transistor trench; again the trench is cleaned and insulating oxide layer 148 is grown on the sidewalls; see FIG.6F.

7. The second stage of excavation of the storage trench is again by RIE with CCl$_4$ and extends the trench about 4.0 microns into substrate 132 beyond the bottom of the transistor trench. Again the trench is cleaned; next n + layer 134 is formed on the walls and bottom of the trench by vapor phase diffusion, and the RIE mask oxide stripped; and lastly, capacitor oxide 136 is grown to a thickness of about 150 A; see FIG.6G.

8. N + doled polysilicon layer 138 is deposited by LPCVD, this partially fills the storage trench, and is patterned to form ground lines over bit line and drain regions 144 (see FIG.5B) and gate 164 of peripheral field effect transistors 160. The n source and drain regions 166 of transistors 160 are then implanted using gate 164 as the mask. Lastly, polysilicon layer 138 is oxidized to fill any voids in the portion of polysilicon layer 138 in the stroage trench (i.e., oxide 154) and the oxide then plasma etched to leave oxide 154 plus handles 168 on gate 164 and layer 138. Further arsenic implants to form n + source and drain regions 170 of transistor 160 can now be made; see FIG.5A.

Note that cell 130 has a capacitor area of about 26 square microns (the bottom is about 2.25 square microns and each of the four sidewalls is about 6 square microns) although the substrate area occupied by the cell is only about 16 square microns.

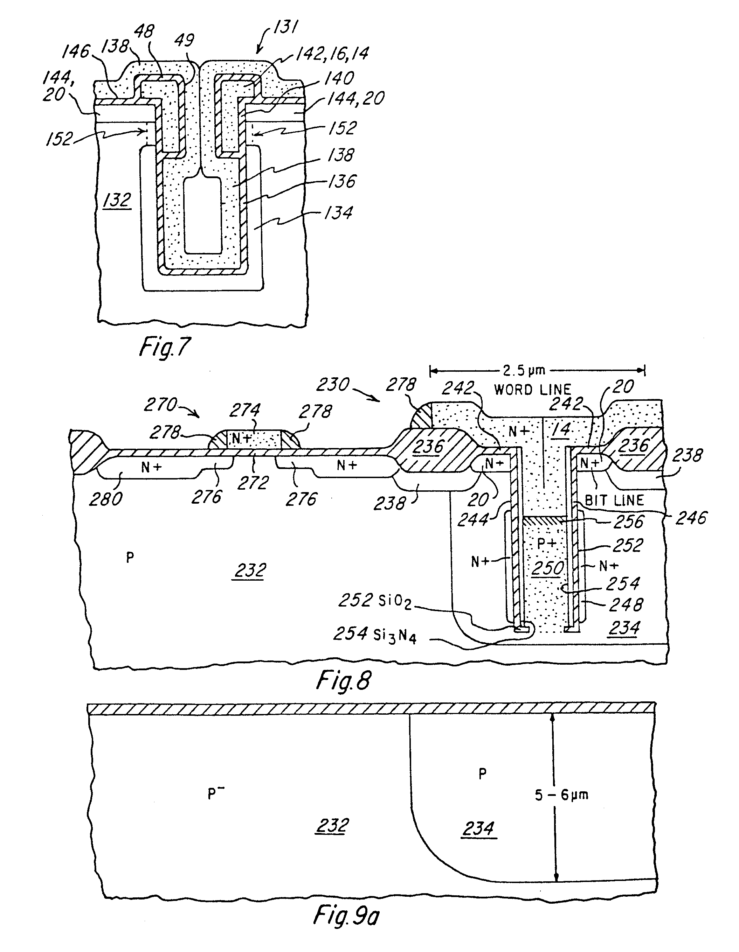

Fourth preferred embodiment cell 131 is illustrated in cross sectional view in FIG. 7; the elements of cell 131 are given the same reference numbers as the corresponding elements of cell 130. Note that in FIG. 7 the bit line 20 and ground line 138 run parallel to the paper and word line 14 runs perpendicular; this is the reverse of FIG. 5A. Also, cell 131 has only a single trench instead of the two level trench of cell 130; this leads to gate 142 forming a neck in the trench and a consequent limit to the amount of polysilicon 138 that can deposit below the neck.

FIG.8 is a cross sectional view of fifth preferred embodiment dRAM cell, generally denoted 230, together with a MOS field effect transistor 270 which may be fabricated simultaneously with cell 230, as described below. Cell 230 is formed in p-silicon substrate 232 with p well 234 and includes field oxide 236, p + channel stops 238, n + buried bit line 20, bit line insulator oxide 242, n + polysilicon word line 14, transistor 18 channel 244, transistor 18 gate oxide 246, n + diffused region 248 which forms one of the plates of capacitor 212, p + polysilicon region 250 which forms the major portion of the other plate of capacitor 12 and connected to substrate ground through the trench bottom, oxide layer 252 and nitride layer 254 which together form the insulator between the plates of capacitor 12, and insulating oxide 256. The view of cell 230 in FIG.8 corresponds to a section along horizontal line 8-8 in FIG.1B; the square cross section of the trench containing capacitor 12 and transistor 18 is apparent in FIG.1B.

In cell 230 capacitor 12 is formed with one of the plates being n + region 248 and the other plate being p + region 250 together with p well 234; regions 248 and 250 are separated by the insulator formed of oxide layer 252 and nitride layer 254, whereas region 250 and well 234 form a reversed biased junction. The doping of p well 234 is very low compared to the doping of p + region 250, so the capacitance of the reversed biased junction is small compared to the capacitance across the insulator provided the insulator is thin. Thus stored charge is effectively isolated across the insulator from the substrate. For a trench with a 1 micron by 1 micron cross section and 5 microns deep, the capacitor plate area would be about 16 square microns if the channel region 244 takes up about 1 micron of the trench depth.

Transistor 18 in cell 230 is entirely in bulk silicon with a polysilicon gate: channel region 244 is part of p well 234, source region 248 (which is also a plate of capacitor 12) and drain region 20 (which is also bit line 20) are n+ diffusions in p well 234, gate oxide 246 is grown on the trench surface of p well 234, and the gate is part of polysilicon word line 14. Insulating oxides 242 and 256 are fairly thick, but gate 14 still overlaps the source and drain slightly along the vertical in FIG.8.

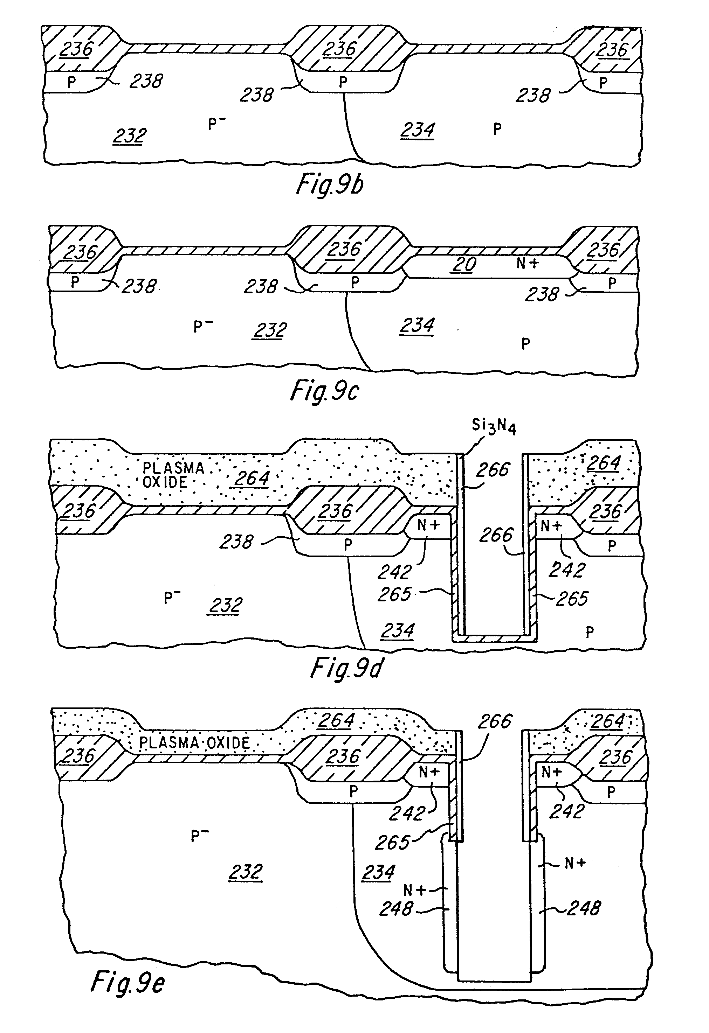

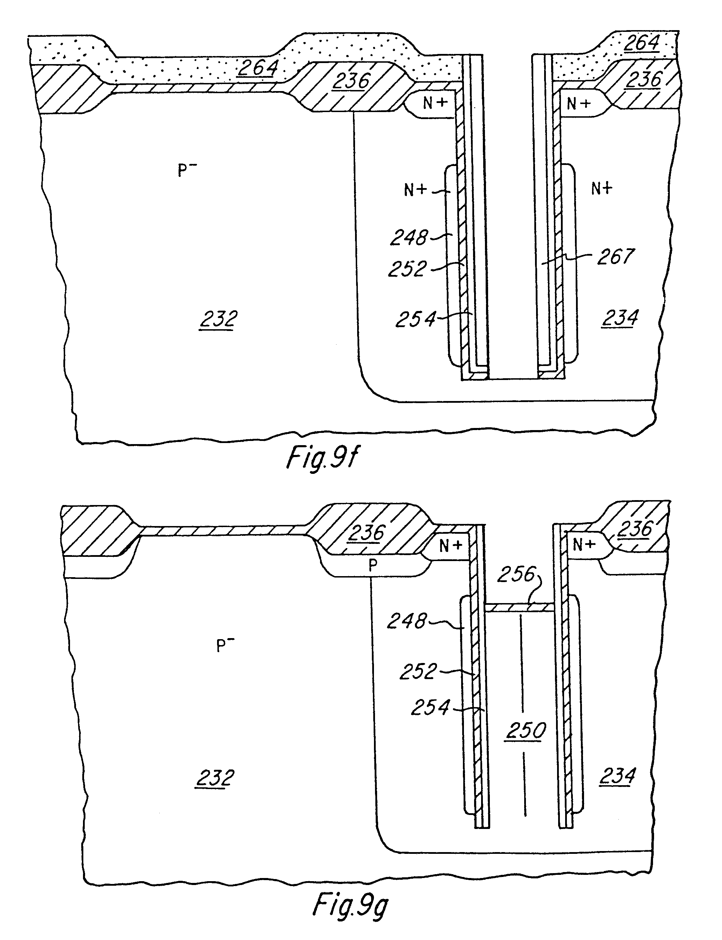

The dimensions and materials characteristics of cell 230are best understood in connection with the following description of a first preferred embodiment method of fabricating cell 230; FIGS.9A-G illustrate the sequence of process steps.

1. (100) oriented p- silicon substrate 232 of resistivity 5-10 ohm-cm has p well 234 formed with a carrier concentration of 2E16 per $cm^3$ to a depth of about 6 microns in the active area to be occupied by cells 230; see FIG.9A.

2. Field oxide 236 and p+ channel stops 238 are formed in the usual manner: a stress relief oxide layer is grown and LPCVD nitride is deposited on the oxide; the active area is patterned and plasma etching removes the nitride and oxide outside the active area; a boron implant using the nitride as a mask creates channel stops 238 to a depth of 4,000 A with a carrier concentration of 1E18 per $cm^3$ ; and field oxide 236 is grown to a thickness of 5,000 A. The nitride is stripped; see FIG.9B.

3. Photolithography defines the portion of the active area to be occupied by bit lines 20, and an arsenic implant forms them to a depth of 2,000 A with a carrier concentration of 1E18 per $cm^3$ ; see FIG.9C for the view after photoresist cleanup and protective oxide growth.

4. 10,000 A of plasma enhanced CVD oxide 264 is deposited and patterned to define the 1 micron square trenches. The patterned oxide 264 is then used as the mask for RIE with $CCl_4$ excavation of the trenches to a depth of 1.0 micron. The trench walls are cleaned of RIE damage and contamination with a wet acid etch, and protective oxide 265 thermally grown on the trench walls and bottom; an LPCVD deposition of nitride 266 in a sidewall process is used to protect the sidewall oxide and limit diffusion in subsequent processing; see FIG.9D.

5. The trench is further excavated again using RIE with $CCl_4$, note that oxide 264 is also being somewhat eroded, but was initially deposited sufficiently thick to avoid problems. After the trench has been excavated to a total depth of about 5.0 microns, it is cleaned and a phosphorus vapor phase diffusion used to form n+ region 248 to a thickness of 2,000 A with a carrier concentration of 1E18 per $cm^3$. The bottom of the trench is also doped by this diffusion, so another 0.5 micron of excavation by RIE with $CCl_4$ is needed to eliminate the doped trench bottom. See FIG.9E.

6. Capacitor 12 place insulator is now formed by thermally growing oxide layer 254 to a thickness of 75 A and LPCVD depositing nitride layer 252 to a thickness of 75 A. This insulator also covers the bottom of the trench, so a protective LPCVD oxide layer 267 is formed over the insulator and RIE with $CCl_4$ used to remove the oxide and nitride layers from the trench bottom; see FIG.9F.

7. Protective oxide 267 is removed (nitride 252 preserving the capacitor insulator from attack and oxide 264 being further eroded) and the trench filled with LPCVD polysilicon 250 n-doped to a carrier concentration of 1E18 per $cm^3$. Polysilicon 250 is planarized, such as with spun on PMMA, and plasma etched completely away on the surface and down into the trench to approximately the level of region 248. Oxide 264 is now removed, this may also remove a little of field oxide 236, but field oxide 236 was sufficiently thick avoid problems; and insulating oxide 256 is grown; see FIG.9G.

8. The exposed portion of oxide 254 and nitride 252 (above insulating oxide 256) is stripped, and gate oxide 246 thermally grown. This stripping also removes the thin oxide on substrate 232 and a little of field oxide 236, so the thermal growth of gate oxide 246 also grows gate oxide 272 for transistor 270. N-doped polysilicon with a carrier concentration of 1E18 per $cm^3$ is deposited by LPCVD and patterned to form word line 14 and transistor gate 274, and a light arsenic implant forms source and drain 276 for transistor 270. Lastly, LPCVD oxide is deposited and plasma etched to leave oxide filaments 78 along the edges of polysilicon 14 and 274, and a heavy arsenic implant forms the source and drain contact regions 280 for transistor 270. See FIG.8.

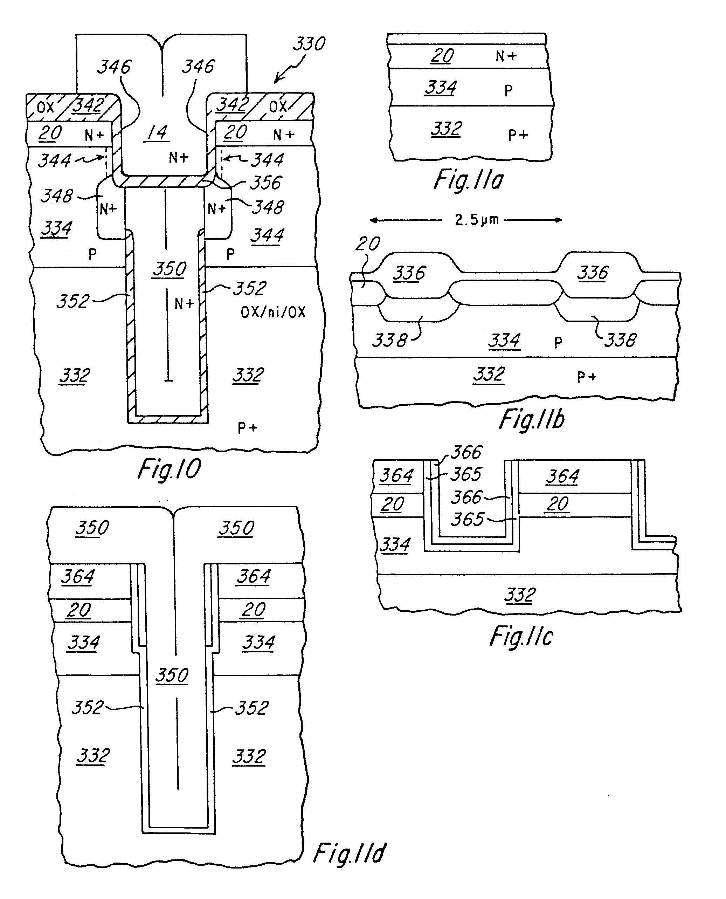

FIG.10 is a cross sectional view of the sixth preferred embodiment dRAM cell, generally denoted 330. Cell 330 is formed in p+ silicon substrate 332 with p epilayer 334 and includes n+ buried bit line 20, bit line insulator oxide 342, n+ polysilicon word line 14, transistor 18 channel 344, transistor 18 gate oxide 346, n+ diffused region 348 which forms the source region for transistor 18, n+ polysilicon region 350 which forms one of the plates of capacitor 12 with p+ substrate 332 forming the other and ground plate, oxide/nitride/oxide stack 352 which forms the insulator between the plates of capacitor 12, and insulating oxide 356. The view of cell 330 in FIG.10 corresponds to a section along vertical line 2-2 in FIG.1B: the square cross section of the trench containing capacitor 12 and transistor 18 is apparent in FIG.1B.

In cell 330 capacitor 12 is formed with one of its plates being n+ regions 348 and 350 and the other plate being substrate 332 plus epilayer 334; however, the doping of epilayer 334 is much lower than that of p+ substrate 332, so the capacitance of the n+/p junction of region 348 and epilayer 334 and the capacitance of n+ region 350/stack 352/p epilayer 334 are both much less than the capacitance of n+ region 350/stack 352/p+ substrate 332 and may be ignored. Also, as will be detailed below, the plate area of epilayer 334 is small compared to that of substrate 332, and this further implies the insignificance of the epilayer 334 capacitance. For a trench with a 1 micron by 1 micron cross section and 5 microns deep, the capacitor 12 plate area would be about 17 square microns if 1 micron of the depth is epilayer 334 and bit line 20. P+ substrate 332 is the ground common to all cells 330 in an array.

Transistor 18 in cell 330 is entirely in bulk silicon with a polysilicon gate: channel region 44 is part of p epilayer 334, source region 348 (which is also a part of a plate of capacitor 12) and drain region 20 (which is also bit line 20) are n+ diffusions in p epilayer 334, gate oxide 346 is grown on the trench surface of p epilayer 334, and the gate is part of polysilicon word line 14. Insulating oxide 342 is fairly thick, but gate 14 still overlaps the source and drain of transistor 18.

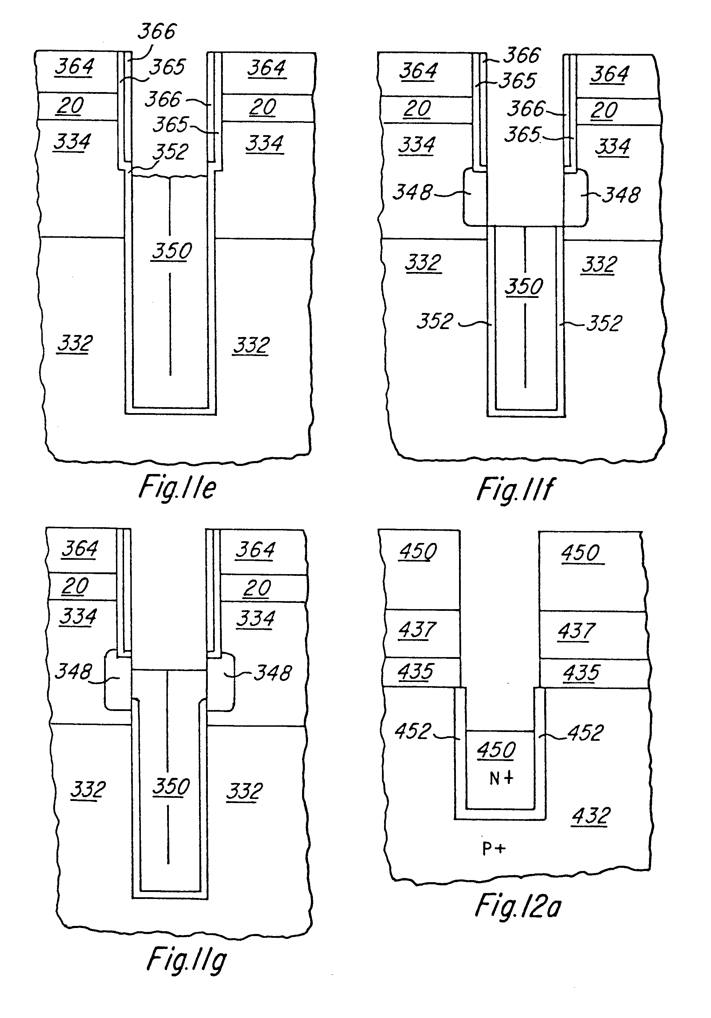

The dimensions and materials characteristics of cell 330 are best understood in connection with the following description of a first preferred embodiment method of fabricating cell 330; FIGS.11A-G illustrate the sequence of process steps.

1. (100) oriented p+ silicon substrate 332 of resistivity less than 1E-2 ohm-cm has p epilayer 334 grown with a carrier concentration of 2E16 per cm$^3$ and thickness such that after all thermal processing the final p epilayer thickness is 2.0 microns. Field oxide 336 and p channel stops 338 are formed in the usual manner: a stress relief oxide layer is grown and LPCVD nitride is deposited on the oxide; the active area (bit lines 20 plus peripheral area outside of the cell array) is patterned and plasma etching removes the nitride and oxide outside the active area; a boron implant using the nitride as a mask creates channel stops 338 to a depth of 4,000 A with a carrier concentration of 1E17 per cm$^3$; and field oxide 336 is grown to a thickness of 8,000 A. The nitride is stripped; photolithography defines the portion of the active area to be occupied by bit lines 20, and an arsenic implant forms them to a depth of 2,000 A with a carrier concentration of 1E20 per cm$^3$; see FIGS.11A-B for the view after photoresist cleanup and protective oxide growth. FIG.11A is a cross section along bit lines 20 and FIG.11B is a cross section perpendicular to bit lines 20; note that bit lines 20 are about 1.5 microns wide as described in connection with FIG.1B.

2. One micron of plasma enhanced CVD oxide 364 is deposited and patterned to define the 1 micron square trenches. The patterned oxide 364 is then used as the mask for RIE with HCl excavation of the trenches to a depth of 1.25 microns. The trench walls are cleaned of RIE damage and contamination with a wet acid etch, and protective oxide 365 thermally grown on the trench walls and bottom; an LPCVD deposition of nitride 366 in a sidewall process is used to protect the sidewall oxide and limit diffusion in subsequent processing; oxide 365 may be about 200 A thick and nitride 366 may be about 1,000 A thick. See FIG.11C which is the cross section along bit lines 20 as are FIGS.11D-H.

3. The trench is further excavated again using RIE with HCl, note that oxide 364 is also being somewhat eroded, but was initially deposited sufficiently thick to avoid problems. After the trench has been excavated to a total depth of about 5.0 microns, it is cleaned and capacitor 12 insulator stack 352 is formed by thermally growing oxide to a thickness of 100 A followed by a LPCVD deposition of nitride to a thickness of 75 A. The nitride is then thermally oxidized to improve the dielectric integrity and this yields the oxide/nitride/oxide stack 352. The trench is filled with n+ doped polysilicon 50; see FIG.11D.

4. Polysilicon 350 is planarized, such as with spun on photoresist, and plasma etched completely away on the surface and down into the trench to 3,000 A below the upper level of insulator stack 352 but above substrate 332. As will be seen below, the location of the top of polysilicon 350 is not crucial provided that it lies somewhat below the top of stack 352 and above substrate 332. See FIG.11E.

5. The exposed portion of stack 352 is stripped (recall nitride 366 is much thicker than stack 352, so the exposed portion of stack 352 may be stripped without removing much of nitride 366), and a phosphorus vapor phase diffusion used to form n+ regions 348 with a thickness of at least 2,000 A; see FIG.11F. Note that in FIG.11F there appear to be two regions 348, but actually they are just part of a single annular region that girdles the trench and forms the source for transistor 18. The gate oxide for transistor 18 has not yet been formed.

6. N+ polysilicon is deposited by LPCVD and planarized and plasma etched completely away on the surface and down into the trench to just below the oxide 365 and nitride 366. Note that this polysilicon just adds to polysilicon 350 and is denoted by the same reference number; see FIG.11G. Note that again the location of the top of polysilicon 350 is not crucial provided that sufficient overlap of polysilicon 350 with region 348 exists for good electrical contact and that all of oxide 365 and nitride 366 are exposed which will insure that the gate of transistor 18 covers all of the channel, as described below.

7. Thermal oxide 356 is grown on the exposed portions of polysilicon 350 and regions 348 to a thickness of about 1,000 A; nitride 366 prevents oxide 365 from growing except for a bird's beak at the lower edge. Oxide 356 is grown to help lower the gate to source parasitic capacitance of transistor 18 and could be omitted. Next nitride 366 is etched and then oxide 365 (and a portion of the much thicker oxide 356) is wet etched away, exposing channel region 344 and a small part of region 348. Gate oxide 346 is grown on channel region 344 to a thickness of 250 A (this also increases the thickness of oxide 356) and n + polysilicon 14 is deposited and patterned to form word lines 14. See FIG.10 for the completed cell.

Seventh preferred embodiment dRAM cell, generally denoted 430, and seventh preferred method of fabrication are illustrated in FIGS.12A-D in cross sectional elevation views analogous to those of FIGS.10 and 11A-G. The processing steps are as follows.

1. (100) oriented p + silicon substrate 432 has 1,000 A of thermal oxide 435 grown and 1 micron of plasma enhanced CVD oxide 437 deposited. Oxide 437 is patterned to define the 1 micron square trenches and then used as the mask for RIE with HCl excavation of the trenches to a depth of 5 microns. The trench walls are cleaned and capacitor oxide 452 thermally grown on the trench sidewalls and bottom to a thickness of 150 A. Next, 4 microns of arsenic doped n + polysilicon 450 is sputter deposited; see FIG.12A.

2. The oxides are wet etched, this removes the exposed portion of capacitor oxide 452 and lifts off the portion of polysilicon 450 on oxide 437. 2,000 A thick layer of 1-2 ohm-cm silicon epilayer 444 is deposited and implanted to form layer 420 which will become n + bit lines 20 and the drain of transistor 18 plus region 448 which will become the source of transistor 18; see FIG.12B. Of course, region 448 is expected to have various faults since it is deposited over polysilicon 450, but this is not significant because the undoped portion of epilayer 444 will become the channel of transistor 18.

3. An anneal causes the implanted donors to diffuse and thereby make region 448 bulge slightly. Gate oxide 446 is thermally grown to a thickness of 250 A, and n + polysilicon 14 is deposited and patterned and etched to form word lines 14. See FIG.12C for the completed cell.

An eighth preferred embodiment cell, generally denoted 460, is a variation of cell 430 and fabricated by eighth preferred embodiment method which is a variation of the second preferred method, as follows, with the same reference numbers used for corresponding features:

1. Follow step 1 and the oxide etch of step 2.

2. 2,000 A thick layer of LPCVD polysilicon 444 is deposited and implanted to form layers n + layers 420 and 448; FIG.4B describes this provided it is understood that regions 420, 444, and 448 are polysilicon and not epilayer as with the second preferred embodiment.

3. Annealing and solid phase epitaxy convert regions 420 and 444 into epilayers on substrate 432. And, a portion of regions 448 and 450 is also converted to single crystal; the wavy lines in FIG.12D suggest this partial crystallization. Note that only the crystallization of region 444 (the channel of transistor 18) significantly affects performance. The high temperatures used in this processing causes some of the donor implants to diffuse, and thus regions 448 bulge out, as shown in FIG.12D. Layer 420 is patterned and etched to form bit lines 20.

4. Gate oxide 446 is thermally grown to a thickness of 250 A, and n + polysilicon 14 is deposited and patterned and etched to form word lines 14. See FIG.12E for the completed cell 460.

Cells 430 and 460 operate in the same manner as cell 330: transistor 18 is oriented vertically with drain 20, channel 444, source 448, and gate 14; and capacitor 12 has n + region 448-450 as one plate, p + substrate 432 as the other plate, and oxide layer 452 plus the reversed biased junction between region 448 and substrate 432 as the dielectric.

A variation in step 3 of the fabrication of cell 460 patterns and etches layer 420 after the solid phase epitaxy to define and implant the channel stops between the bit lines 20; see FIG.11B for the fabrication of channel stops 38 between bit lines 20 in the seventh preferred embodiment method of fabrication.

MODIFICATIONS AND ADVANTAGES

Many modifications of the preferred embodiments are available which still fall within the scope of the appended claims in that such modifications either singly or in combinations, do not disrupt the storage of signal charge by the capacitor nor the on/off function of the transistor. Such modifications include the following:

The trench cross section could be whatever shape is convenient, such as circular, rectangular, arbitrary convex, corrugated, even multiconnected and could even vary along the vertical, continuously or in steps or both. Similarly, the trench sidewalls need not be vertical, rather any geometry that can be processed should work to a greater or lesser extent, such as bulging, tapered, and sloped sidewalls; indeed, any simply connected trench is homeomorphic to the parallelepipes of the preferred embodiments. Lastly, the dimensions of the trench (depth, cross sectional area, diameter, and so forth) may be varied but in practice are a tradeoff of process convenience, capacitance required, substrate area, and so forth. Of course, the capacitance required defends upon the refresh time, transistor leakage current, supply voltage, soft error immunity, capacitor leakage current, et cetera.

The capacitor insulator can be of any convenient material such as oxide, nitride, oxide-nitride, oxide-nitride-oxide, and other stack combinations of these or other insulators, and the oxide could be thermally grown in a variety of ambients, LPCVD or plasma deposited, and so forth. The thickness of the insulator is a tradeoff of process convenience, insulator reliability, dielectric constant, breakdown voltage, and so forth and may vary widely. Of course, if the cell and array are fabricated in semiconductor material other than silicon (such as gallium arsenide, aluminum gallium arsenide, mercury cadmium telluride, germanium, indium phosphide, and so forth), the capacitor insulator will be a corresponding material. Similarly, recrystallized amorphous silicon could be used in place of polysilicon; such recrystallization may be by energy beam or annealing.

The transistor can be formed to operate with a variety of threshold voltages by adjusting the threshold voltage (such as by a shallow diffusion or ion implant on the channel just prior to gate oxide growth or deposition), in the accumulation or inversion mode, and as n-channel or p-channel device. The doping levels and the doping species can be varied so as to vary the transistor characteristics; also the polysilicon transistors can be formed with a thin channel that fully depletes to limit the leakage current. Note that the transistor channel length for the embodiments with transistor in the trench may vary widely and channel width is roughly equal to the trench perimeter.

The transistor gate may be polysilicon, metal, silicide, and so forth. All of these variations affect performance of the transistor but are acceptable if the transistor adequately performs as a pass transistor for the cell in view of the other characteristics of the cell including required read and write times, the capacitance, the refresh time, and so forth.

Of course, the preferred embodiment cells may be used in a variety of arrays, not just the cross point array of Fig. 1B.

The advantages of the preferred embodiment dRAM cells, array of cells, and methods of fabrication include the small substrate area occupied, the relatively standard process techniques usable for fabrication, the possibility of having the stored charge isolated from the substrate by oxide or by reversed biased junction, the possibility of a polysilicon transistor channel which is oxide-isolated from the substrate or a transistor channel which is formed in the bulk substrate, and the possibility of bit lines and word lines isolated from the substrate. These advantages translate into a dense packing of cells, noise and alpha particle immunity, low stray capacitance, and so forth.

## Claims

1. A dynamic semiconductor memory cell (30) formed in a semiconductor material (32, 34) and comprising a capacitor (44, 46, 48) with first (44) and second (48) capacitor electrodes formed in a trench in said substrate and a field effect transistor (18) connected to said capacitor, characterized in that said first capacitor plate (48) includes a portion of the sidewalls of said trench and said second capacitor plate (44) includes material inserted into said trench and in that the channel of the field effect transistor is formed in semiconductor material inserted into said trench and is adjacent to the trench sidewalls and conductively connected to said second capacitor plate the gate of the field effect transistor being formed adjacent to and outside of the trench.

2. A semiconductor memory cell as claimed in claim 1 and characterized in that said channel surrounds an upper portion of said trench.

3. A semiconductor memory cell as claimed in claim 1 or claim 2 and characterized in that said channel is disposed in a material formed within said trench.

4. A semiconductor memory cell as claimed in any preceding claim and characterized in that a substantial region of said material surrounding said insulating storage node is doped N+ or P+.

5. A semiconductor memory cell as claimed in any preceding claim and characterized in that said storage node is a capacitor plate and further characterized in that there exists a heavily doped region formed in said material separated from said capacitor plate by dielectric material, said heavily doped region serving as a second capacitor plate.

6. A memory cell array characterized in that the array includes a plurality of semiconductor memory cells as claimed in any preceding claim.

7. A memory cell array as claimed in claim 6 and characterized in that it includes a plurality of parallel first conductor lines on said material and a plurality of second conductor lines crossing said first conductor lines but insulated therefrom at crossing points and further characterized in that the trench of each of said plurality of semiconductor memory cells is formed substantially at a said crossing point.

## Revendications

1. Cellule de mémoire dynamique à semiconducteur (3O) formée dans un matériau semiconducteur (32, 34) et comprenant un condensateur (44, 46, 48) ayant une première (44) et une seconde (48) électrodes de condensateur formées dans une tranchée dans ledit substrat et un transistor à effet de champ (18) relié audit condensateur, caractérisé en ce que la première armature de condensateur (48) comprend une partie des parois latérales de ladite tranchée et ladite seconde armature de condensateur (44) comprend un matériau inséré dans ladite tranchée et en ce que le canal du transistor à effet de champ est formé dans un matériau semiconducteur inséré dans ladite tranchée et est adjacent aux parois latérales de la tranchée et relié par conduction à ladite seconde armature de condensateur, la grille du transistor à effet de champ étant formée adjacente à la tranchée et à l'extérieur de celle-ci.

2. Cellule de mémoire à semiconducteur selon la revendication 1 et caractérisée en ce que ledit canal entoure une partie supérieure de ladite tranchée.

3. Cellule de mémoire à semiconducteur selon la revendication 1 ou la revendication 2, caractérisée en ce que ledit canal est disposé dans un matériau formé dans ladite tranchée.

4. Cellule de mémoire à semiconducteur selon l'une quelconque des revendications précédentes, caractérisée en ce qu'une zone importante dudit matériau entourant ledit noeud de stockage d'isolation est dopée $N^+$ ou $P^+$.

5. Cellule de mémoire à semiconducteur selon l'une quelconque des revendications précédentes, caractérisée en ce que ledit noeud de stockage est une armature de condensateur et caractérisée en outre en ce qu'il existe une zone fortement dopée formée dans ledit matériau, séparée de ladite armature de condensateur par un matériau diélectrique, ladite zone fortement dopée servant de seconde armature de condensateur.

6. Réseau de cellules de mémoire à semiconducteur, caractérisé en ce que le réseau comprend une pluralité de cellules de mémoire à semiconducteur selon l'une quelconque des revendications précédentes.

7. Réseau de cellules de mémoire selon la revendication 6, caractérisé en ce qu'il comprend une pluralité de premières lignes de conducteur parallèles sur ledit matériau et une pluralité de secondes lignes de conducteur croisant lesdites premières lignes de conducteur mais isolées de celles-ci aux points de croisement et caractérisé en outre en ce que la tranchée de chacune de ladite pluralité de cellules de mémoire à semiconducteur est formée principalement audit point de croisement.

## Patentansprüche

1. Dynamische Halbleiterspeicherzelle (30) in einem Halbleitermaterial (32, 34) mit einem Kondensator (44, 46, 48) mit ersten (44) und zweiten (48) Kondensatorbelägen, die in einem Graben in dem Substrat gebildet sind, und einem Feldeffekttransistor (18), der mit dem Kondensator verbunden ist, dadurch gekennzeichnet, daß der erste Kondensatorbelag (48) einen Teil der Seitenwand des Grabens enthält und der zweite Kondensatorbelag (44) in den Graben eingefülltes Material enthält, und daß der Kanal des Feldeffekttransistors in einem Halbleitermaterial gebildet ist, das in den Graben eingefüllt ist und an die Grabenseitenwände angrenzt sowie leitend mit dem zweiten Kondensatorbelag verbunden ist, wobei das Gate des Feldeffekttransistors angrenzend an den Graben und außerhalb des Grabens gebildet ist.

2. Halbleiterspeicherzelle nach Anspruch 1, dadurch gekennzeichnet, daß der Kanal einen oberen Abschnitt des Grabens umgibt.

3. Halbleiterspeicherzelle nach Anspruch 1 oder 2, dadurch gekennzeichnet, daß der Kanal in einem Material angeordnet ist, das innerhalb des Grabens gebildet ist.

4. Halbleiterspeicherzelle nach einem der vorhergehenden Ansprüche, dadurch gekennzeichnet, daß ein beträchtlicher Bereich des Materiales, das den isolierten Speicherpunkt umgibt, $N^+$ - oder $P^+$ - dotiert ist.

5. Halbleiterspeicherzelle nach einem der vorgehenden Ansprüche, dadurch gekennzeichnet, daß der Speicherpunkt ein Kondensatorbelag ist und ferner dadurch gekennzeichnet, daß eine in dem Material gebildete stark dotierte Zone vorhanden ist, die von dem Kondensatorbelag durch dielektrisches Material getrennt ist, wobei die stark dotierte Zone als zweiter Kondensatorbelag dient.

6. Speicherzellenmatrix, dadurch gekennzeichnet, daß die Matrix mehrere Halbleiterspeicherzellen gemäß einen der vorhergehenden Ansprüche enthält.

7. Speicherzellenmatrix nach Anspruch 6, dadurch gekennzeichnet, daß sie mehrere parallele erste Leiter auf dem Material und mehrere zweite Leiter enthält, die die ersten Leiter kreuzen, jedoch an den Kreuzungspunkten von diesen isoliert sind, und ferner dadurch gekennzeichnet, daß der Graben jeder der mehreren Speicherzellen im wesentlichen an einem solchen Kreuzungspunkt gebildet ist.

Fig.1a

Fig.1b

Fig.2

Fig. 3a

Fig. 3b

Fig. 3c

Fig. 4

Fig. 5b

Fig.5a

*Fig.6a*

*Fig.6b*

*Fig.6c*

*Fig.6d*

*Fig. 6e*

*Fig. 6f*

*Fig. 6g*

Fig.7

252 SiO₂

254 Si₃N₄

Fig.8

Fig.9a

Fig.9b

Fig.9c

Fig.9d

Fig.9e

Fig.9f

Fig.9g

EP 0 187 237 B1

Fig.10

Fig.11a

Fig.11b

Fig.11c

Fig.11d

Fig.11e

Fig.11f

Fig.11g

Fig.12a

Fig.12b

Fig.12c

Fig.12d

Fig.12e